# EUROPÄISCHE PATENTSCHRIFT

(11) **EP 1 085 517 B1**
(45) Veröffentlichungstag und Bekanntmachung des Hinweises auf die Patenterteilung: **06.06.2007**
(21) Anmeldenummer: 00119661.7
(22) Anmeldetag: 08.09.2000
(51) Int. Cl.: G11C 11/407, G11C 11/22, G11C 29/00

(54) **Integrierter Speicher mit wenigstens zwei Plattensegmenten**
Integrated memory circuit with at least two plate segments
Circuit mémoire intégré avec au moins deux segments de plaque

(30) Priorität: 14.09.1999 DE 19944036
(43) Veröffentlichungstag der Anmeldung: 21.03.2001
(73) Patentinhaber: Infineon Technologies AG, 81669 München (DE)
(72) Erfinder: Pöchmüller, Peter, 81739 München (DE)
(74) Vertreter: Epping - Hermann - Fischer

(56) Entgegenhaltungen:
- US-A- 5 400 275

## Beschreibung

Die Erfindung betrifft einen integrierten Speicher mit Speicherzellen, die innerhalb eines Zellenfeldes entlang von Bitleitungen, Wortleitungen und wenigstens zwei Plattensegmenten angeordnet sind und jeweils einen Auswahltransistor und einen Speicherkondensator aufweisen, wobei eine Elektrode jedes Speicherkondensators über den zugehörigen Auswahltransistor mit einer der Bitleitungen und eine andere Elektrode mit einem der Plattensegmente verbunden ist und wobei ein Steueranschluß jedes Auswahltransistors mit einer der Wortleitungen verbunden ist.

Ein derartiger integrierter Speicher in Form eines FRAMs (Ferro Electric Random Access Memory) ist in der US 5 373 463 A beschrieben. Dort ist eine erste Variante eines FRAMs gezeigt, bei dem die Plattensegmente parallel zu den Wortleitungen angeordnet sind, wobei jeweils ein Plattensegment einer Wortleitung zugeordnet ist. Weiterhin ist eine andere Variante gezeigt, bei dem Plattensegmente parallel zu den Bitleitungen verlaufen, wobei jeweils ein Plattensegment einer Bitleitung zugeordnet ist. Die in der US 5 373 463 A beschriebenen Speicher arbeiten nach dein sogenannten "Pulsed Plate - Konzept". Beim Einschreiben oder Auslesen von Informationen in die bzw. aus den Speicherzellen wird eine der Wortleitungen aktiviert, so das die zugehörigen Auswahltransistoren leitend geschaltet werden, und anschließend wird das Plattensegment, daß derjenigen Speicherzelle zugeordnet ist, auf die ein Zugriff erfolgen soll, zunächst auf ein hohes Versorgungspotential und anschließend auf ein niedriges Versorgungspotential des Speichers gebracht, d. h. gepulst. Jeder Zugriff auf eine der Speicherzellen ist also mit einem Pulsen des zugehörigen Plattensegments verbunden. Das Dokument US 5400275 zeigt bekannte Datenspeicher gemäß des Oberbegriffs des Anspruchs 1.

Bei ferroelektrischen Speicherzellen, deren Speicherkondensatoren ein ferroelektrisches Dielektrikum aufweisen, treten Alterungserscheinungen wie der sogenannte "Imprint" oder das sogenannte "Fatigue" auf, die zu Funktionsstörungen des Speichers führen können. Daher ist es wichtig, im Rahmen eines Speichertests zu überprüfen, ob die Speicherzellen wenigstens gewissen minimalen Anforderungen an ihre Alterungsbeständigkeit erfüllen. Um die Alterungseffekte zu überprüfen, ist es möglich, auf jede Speicherzelle eine große Anzahl von Schreib- bzw. Lesezugriffen durchzuführen. Abschließend wird die Funktionsfähigkeit jeder Zelle überprüft, so das festgestellt werden kann, ob bereits erste Defekte aufgrund einer vorzeitigen Alterung aufgetreten sind, die einen Einsatz des Speichers unmöglich machen. Da heutige Speicher eine Vielzahl von Speicherzellen aufweisen, ist das beschriebene Testen der Speicherzellen sehr zeitaufwendig.

Der Erfindung liegt daher die Aufgabe zugrunde, einen integrierten Speicher der genannten Art anzugeben, bei dem ein Prüfen der Speicherzellen durch die Durchführung einer Vielzahl von Speicherzugriffen mit reduziertem Zeitaufwand möglich ist.

Diese Aufgabe wird mit einem integrierten Speicher gemäß Patentanspruch 1 gelöst. Vorteilhafte Aus- und Weiterbildungen der Erfindung sind Gegenstand der abhängigen Ansprüche.

Die Speicherzellen des erfindungsgemäßen Speichers sind jeweils mit einer von wenigstens zwei Plattensegmenten verbunden. In einer Normalbetriebsart des Speichers erfolgen Zugriffe auf die Speicherzellen, indem das Potential jeweils nur eines der Plattensegmente gepulst wird. In einer Testbetriebsart dagegen werden gleichzeitig die Potentiale beider Plattensegmente gepulst.

Die Erfindung beruht auf der Erkenntnis, daß es zwar im Normalbetrieb eines Speichers notwendig ist, Zugriffe exakt auf einzelne Speicherzellen durchzuführen, daß dies jedoch für eine künstliche Alterung der Speicherzellen in einer Testbetriebsart nicht notwendig ist. Vielmehr kann in der Testbetriebsart ein Zugriff auf eine größere Anzahl von Speicherzellen erfolgen als in der Normalbetriebsart. Erfindungsgemäß geschieht dies durch Pulsen einer unterschiedlichen Anzahl von Plattensegmenten in den beiden Betriebsarten.

Nach einer Weiterbildung der Erfindung werden die Potentiale der beiden Plattensegmente in der Testbetriebsart gleichzeitig in jeweils entgegengesetzter Richtung gepulst. Dies bedeutet, daß die Plattensegmente in der Testbetriebsart komplementäre Pegel, die beispielsweise Versorgungspotentialpegel des Speichers sein können, annehmen. Auf diese Weise wird erreicht, daß aufgrund von kapazitiven Kopplungen zwischen den Plattensegmenten und den Bitleitungen einerseits sowie den Plattensegmenten und den Wortleitungen andererseits auftretende Effekte sich wenigstens teilweise gegenseitig kompensieren. Diese Kompensation ist um so größer, je näher die beiden Plattensegmente zueinander angeordnet sind. Daher ist es insbesondere vorteilhaft, wenn die Plattensegmente unmittelbar benachbart zueinander angeordnet sind.

Nach einer weiteren Weiterbildung der Erfindung werden die Potentiale der beiden Plattensegmente in der Testbetriebsart jeweils durch zwei aufeinander folgende Pulse mit jeweils entgegengesetzten Pegeln gepulst und der Speicher weist ein Kurzschlußelement auf, das die beiden Plattensegmente miteinander verbindet und das vor dem zweiten Pulsen der Plattenpotentiale vorübergehend leitend geschaltet ist.

Auf diese Weise wird erreicht, daß vor dem Pulsen der beiden Plattensegmente auf jeweils entgegengesetzte Pegel ein Ladungsausgleich über das leitende Kurzschlußelement erfolgt, so daß zur Erreichung des nachfolgend zu pulsenden Pegels weniger Leistung erforderlich ist, als ohne das Kurzschließen.

Nach einer Ausführungsform der Erfindung verlaufen die Plattensegmente parallel zu den Wortleitungen und in der Testbetriebsart ist pro Plattensegment wenigstens eine der zugehörigen Wortleitungen während des Pulsens der Plattenpotentiale aktiviert.

Hierdurch kommt es während des Pulsens der Plattenpotentiale für die beiden Plattensegmente zu gegensätzlichen Ladungsverschiebungen auf denjenigen Bitleitungen, die Speicherzellen zugeordnet sind, auf die jeweils ein Zugriff erfolgt. Diese gegensätzlichen Ladungsverschiebungen bzw. Ströme mit entgegengesetztem Vorzeichen resultieren aus dem entgegengesetzten Potentialpulsen der beiden Plattensegmente. Durch die Aktivierung je einer Wortleitung pro Plattensegment sind sowohl Speicherzellen des einen als auch des anderen Plattensegments über ihre Auswahltransistoren mit derselben Bitleitung verbunden. Während nun aufgrund eines positiven Pulses auf dem einen Plattensegment beispielsweise ein positiver Strom auf die Bitleitungen fließt, bewirkt der negative Puls auf dem anderen Plattensegment einen entsprechenden negativen Puls auf derselben Bitleitung. Die beiden Ströme mit entgegengesetzten Vorzeichen kompensieren sich auf der Bitleitung zumindest teilweise. Durch die Kompensation der gleichzeitig fließenden positiven und negativen Ladungen müssen keine großen elektrischen Ladungen von den Bitleitungen abgeführt werden. Entsprechende Leitungen, die große Ströme führen können, sind also bei der Erfindung nicht notwendig. Insbesondere, wenn die beiden gleichzeitig gepulsten Plattensegmente zueinander benachbart angeordnet sind, fließen lokale Ausgleichs- bzw. Kompensationsströme nur in Teilbereichen der betroffenen Bitleitungen. Hierdurch werden größere parasitäre Spannungsabfälle entlang der Bitleitungen vermieden.

Nach einer anderen Ausführungsform der Erfindung sind die Plattensegmente parallel zu den Bitleitungen angeordnet und in der Testbetriebsart wird pro Plattensegment wenigstens eine der zugehörigen Wortleitungen aktiviert. Außerdem weist der Speicher eine Potentialleitung für ein festes Potential auf sowie wenigstens zwei. Kurzschlußelemente, über die jeweils eine der jedem Plattensegment zugeordneten Bitleitungen mit der Potentialleitung verbunden ist und die in der Testbetriebsart während des Pulsens der Plattenpotentiale beide leitend sind.

Da bei dieser Ausführungsform die Plattensegmente parallel zu den Bitleitungen verlaufen, betrifft das gleichzeitige Pulsen beider Plattensegmente nicht dieselbe Bitleitung. Daher sind die Kurzschlußelemente und die Potentialleitungen notwendig, um die weiter oben beschriebene Ladungskompensation während des entgegengesetzten Pulsens der Plattensegmente zu erreichen. Bei dieser Ausführungsform erfolgt also die Ladungskompensation zwischen zwei Bitleitungen, die unterschiedlichen Plattensegmenten zugeordnet sind. Ansonsten gilt für diese Ausführungsform der Erfindung das zu der vorstehend erläuterten Ausführungsform Gesagte.

Bei beiden vorstehend erläuterten Ausführungsformen der Erfindung ist es möglich, in der Testbetriebsart pro Plattensegment mehr als eine Wortleitung gleichzeitig zu aktivieren. Hierdurch kann die Anzahl der Speicherzellen, auf die gleichzeitig zugegriffen wird, vervielfacht werden. Durch die geschilderte Ladungs- bzw. Stromkompensation kommt es trotz des gleichzeitigen Zugriffs auf eine große Anzahl von Speicherzellen zu keinen extrem großen Strömen auf den Bitleitungen.

Die Erfindung wird im folgenden anhand der Figuren näher erläutert, die Ausführungsbeispiele darstellen. Es zeigen:
- Figur 1: ein erstes Ausführungsbeispiel der Erfindung,
- Figur 2: ein zweites Ausführungsbeispiel und
- Figur 3: Potentialverläufe von Plattensegmenten aus den Figuren 1 und 2.

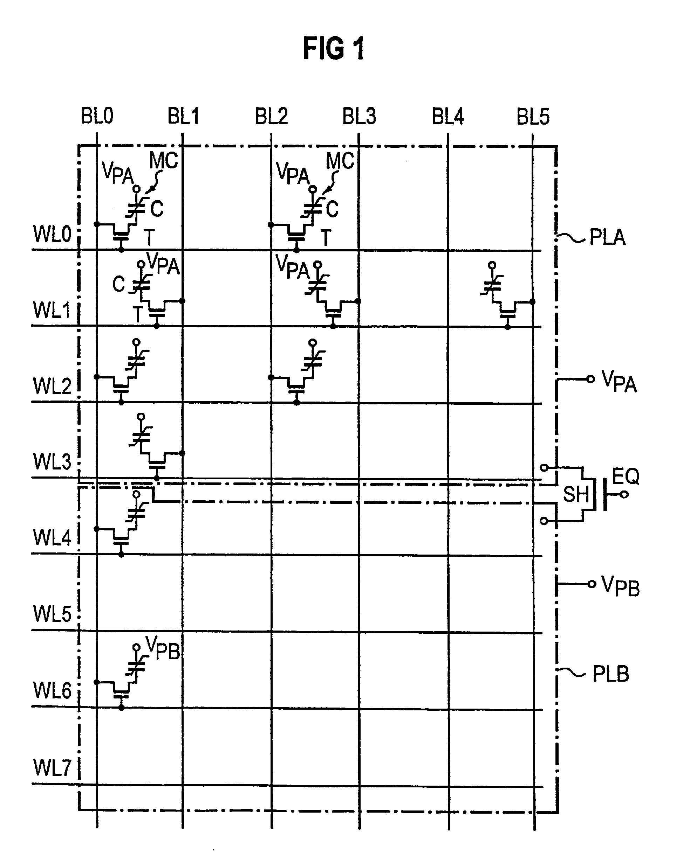

Figur 1 ist ein Ausschnitt eines Speicherzellenfeldes eines integrierten Speichers vom Typ FRAM bzw. FeRAM zu entnehmen. Die Speicherzellen MC sind in Kreuzungspunkten von Bitleitungen BLi, und Wortleitungen WLi angeordnet. Jede Speicherzelle MC weist einen Auswahltransistor T und einen Speicherkondensator C mit ferroelektrischem Dielektrikum auf. Die eine Elektrode jedes Speicherkondensators C ist über die steuerbare Strecke des zugehörigen Auswahltransistors T mit einer der Bitleitungen BLi verbunden. Die andere Elektrode des Speicherkondensators C ist mit einem von zwei Plattensegmenten PLA, PLB verbunden. Das Gate des Auswahltransistors T ist mit einer der Wortleitungen Wli verbunden.

Die Plattensegmente PLA, PLB verlaufen parallel zu den Wortleitungen WLi. Jeweils vier der Wortleitungen sind einem der Plattensegmente zugeordnet. Das bedeutet, daß die mit diesen Wortleitungen verbundenen Speicherzellen mit dem entsprechenden Plattensegment verbunden sind. Obwohl in der Figur 1 lediglich sechs Bitleitungen BLi dargestellt sind, weist der Speicher in Wirklichkeit eine weitaus größere Anzahl von Bitleitungen auf. Außerdem weist er zusätzlich zu den beiden in Figur 1 dargestellten Plattensegmenten PLA, PLB weitere gleichartige Plattensegmente auf, denen jeweils wieder vier der Wortleitungen WLi zugeordnet sind. Den Plattensegmenten PLA, PLB werden von entsprechenden Potentialgeneratoren erzeugte Potentiale V_{PA}, V_{PB} zugeführt.

Die beiden Plattensegmente PLA, PLB sind über ein Kurzschlußelement SH in Form eines n-Kanal-Transistors miteinander verbunden, der beide in Abhängigkeit eines Steuersignals EQ an seinem Gate kurzschließt.

Die Funktionsweise der in Figur 1 gezeigten Schaltung ist folgende: In einer Normalbetriebsart des Speichers wird bei einem Zugriff auf eine der Speicherzellen MC eine der Wortleitungen WLi, beispielsweise die Wortleitung WL1, aktiviert, daß heißt auf einen hohen Pegel gebracht. Hierdurch werden die Auswahltransistoren T derjenigen Speicherzellen, die mit der Wortleitung WL1 verbunden sind, leitend geschaltet. Anschließend wird das der jeweiligen aktivierten Wortleitung WL1 zugeordnete Plattensegment, in diesem Fall das obere Plattenssegment PLA in Figur 1, zunächst auf ein hohes und anschließend auf ein niedriges Versorgungspotential des Speichers gepulst. Bei einem Lesezugriff wird in Abhängigkeit des jeweils im Speicherkondensator gespeicherten Datums, das eine unterschiedliche Polarisierung des ferroelektrischen Dielektrikums des Speicherkondensators C zur Folge hat, das Potential der zugehörigen Bitleitung BL 1, BL 3, BL 5 in unterschiedlich starker Weise verändert. Durch Auswahl einer der drei betroffenen Bitleitungen BL 1, BL 3, BL 5 wird letztlich entschieden, welches Datum verstärkt nach außerhalb des Speichers ausgelesen wird.

In der Normalbetriebsart wird immer nur das Potential eines der Plattensegmente PLA, PLB gepulst, nämlich dasjenige, daß einer jeweils zu aktivierenden Wortleitung WLi zugeordnet ist. Die Segmentierung der Platte hat gegenüber einer ganzflächig ausgeführten, allen Speicherzellen MC gemeinsamen Platte den Vorteil, daß beim Pulsen der Potentiale der einzelnen Plattensegmente daraus resultierende Beeinflussungen nur eine begrenzte Anzahl von Speicherzellen betreffen, auf die beim aktuellen Zugriff gar nicht zugegriffen werden soll.

In einer Testbetriebsart des Speichers werden alle vier Wortleitungen WLi jedes Plattensegments PLA, PLB gleichzeitig aktiviert, so daß alle mit diesen verbundenen Speicherzellen MC leitend mit den Bitleitungen BLi verbunden sind. Anschließend werden beide Plattensegmente PLA, PLB gleichzeitig gepulst. Hierdurch wird erreicht, daß ein Zugriff auf alle Speicherzellen MC gleichzeitig simuliert wird. Auf dieser Weise kann in kurzer Zeit eine künstliche Alterung sämtlicher Speicherzellen MC herbeigeführt werden.

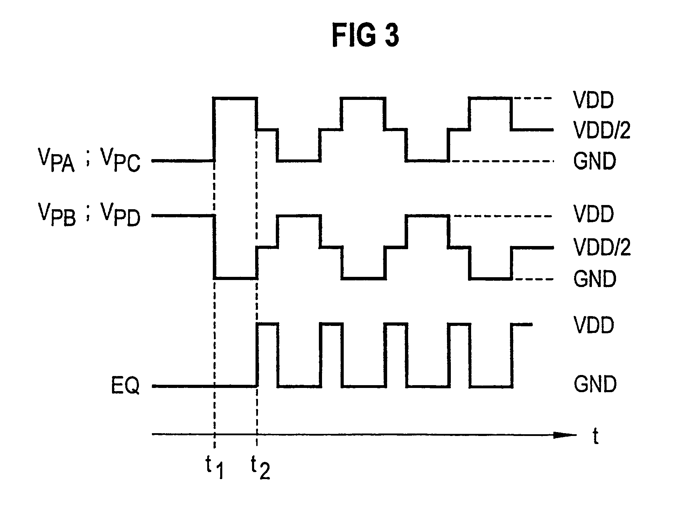

Figur 3 zeigt die Verläufe der Plattenpotentiale V_{PA}, V_{PB} in der Testbetriebsart. Während des betrachteten Zeitraums sind sämtliche Wortleitungen WLi aktiviert. Dargestellt sind drei aufeinanderfolgende Pulse. Zu einem Zeitpunkt t₁ hat das Potential V_{PA} des oberen Plattensegments PLA aus Figur 1 den Wert eines hohen Versorgungspotentials VDD, während das Potential V_{PB} des unteren Plattensegments PLB ein niedriges Potential GND annimmt. Durch die positive Flanke des Potentials V_{PA} werden aus den mit den oberen Plattensegment PLA verbundenen Speicherzellen MC positive Ladungen auf die Bitleitungen BLi verschoben. Durch die negative Flanke des Potentials V_{PB} werden negative Ladungen von den mit dem unteren Plattensegment PLB verbundenen Speicherzellen MC auf die Bitleitungen BLi verschoben, oder, anders ausgedrückt, es werden positive Ladungen von den Bitleitungen BLi in diese Speicherzellen MC abgezogen. Diese entgegengesetzten Ladungsströme kompensieren sich auf den Bitleitungen BLi, so daß keine überschüssigen Ladungen in nennenswerter Höhe von diesen mehr abgeführt werden müssen. Daher sind keine zusätzlichen Komponenten notwendig, um derartige Ladungen abzuführen. Da die Plattensegmente PLA, PLB unmittelbar benachbart zueinander angeordnet sind, werden große Ausgleichsströme auf den Bitleitungen BLi vermieden.

Figur 3 ist zu entnehmen, daß zu einem Zeitpunkt t₂ über das Steuersignal EQ des Kurzschlußelements SH ein Kurzschließen der beiden Plattensegmente PLA, PLB erfolgt. Hierdurch erfolgt ein Ladungsausgleich zwischen den beiden Plattensegmenten, so daß sie anschließend ein gemeinsames Mittelpotential aufweisen, das zwischen den beiden Versorgungspotentialen VDD, GND des Speichers liegt. Nach dem Kurzschließen, nachdem das Steuersignal EQ wieder einen niedrigen Pegel angenommen hat, werden die beiden Plattenpotentiale V_{PA}, V_{PB} auf Pegel gebracht, die entgegengesetzt zu denjenigen sind, die sie vor dem Kurzschließen hatten. Durch das Kurzschließen wird erreicht, daß zum Umladen der Plattensegmente nur relativ wenig Energie erforderlich ist. Um die künstliche Alterung der Speicherzellen MC zu erreichen, folgen auf diesen soeben geschilderten einzelnen Puls weitere Pulse der Plattenpotentiale V_{PA}, V_{PB}.

Obwohl beim hier geschilderten Ausführungsbeispiel sämtliche Wortleitungen WLi der Plattensegmente PLA, PLB in der Testbetriebsart gleichzeitig aktiviert werden, sind andere Ausführungsarten möglich, bei denen in der Testbetriebsart lediglich ein Teil der jedem Plattensegment zugeordneten Wortleitungen aktiviert wird. Beispielsweise kann lediglich eine Wortleitung pro Plattensegment aktiviert werden. Weiterhin ist es möglich, daß jedem Plattensegment mehr als vier Wortleitungen zugeordnet sind, von denen in der Testbetriebsart alle oder ein Teil aktiviert werden.

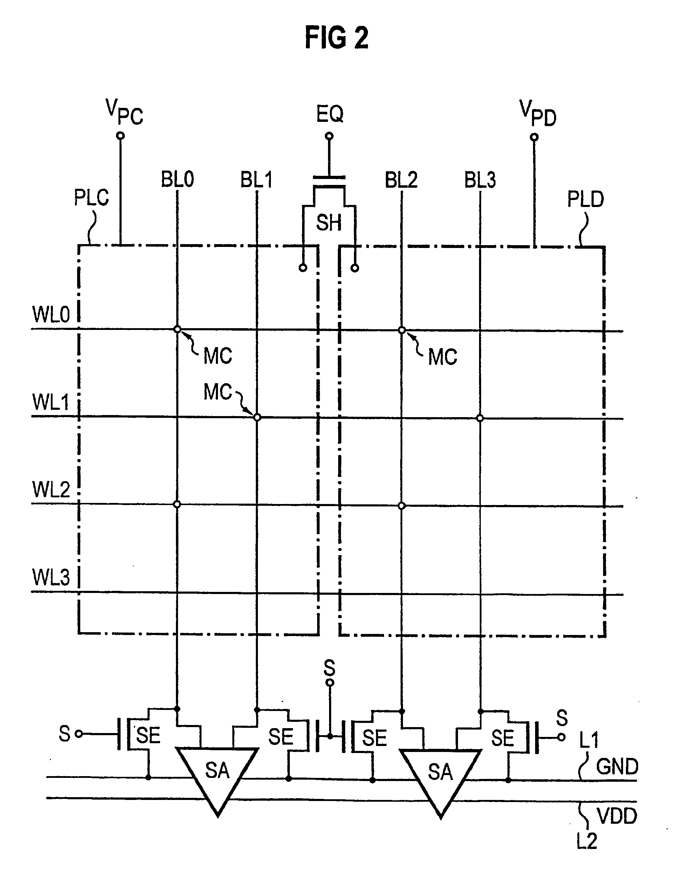

Figur 2 ist ein zweites Ausführungsbeispiel der Erfindung zu entnehmen, daß ebenfalls ein integrierter Speicher vom Typ FRAM ist. Seine Speicherzellen MC sind ebenso wie diejenigen in Figur 1 aufgebaut. Sie sind wiederum in Kreuzungspunkten von Bitleitungen BLi und Wortleitungen WLi angeordnet. In Figur 2 sind lediglich einige der Speicherzellen MC bezüglich ihrer Anordnung angedeutet. Bei diesem Ausführungsbeispiel verlaufen die Plattensegmente PLC, PLD nicht parallel zu den Wortleitungen, wie es bei dem Ausführungsbeispiel aus Figur 1 der Fall ist, sondern parallel zu den Bitleitungen BLi. Jedem Plattensegment PLC, PLD sind zwei der Bitleitungen BLi zugeordnet. Bei anderen Ausführungsbeispielen ist selbstverständlich auch eine größere Zahl von Bitleitungen pro Plattensegment möglich. Von den zahlreichen Wortleitungen WLi, die die Bitleitungen BLi kreuzen sind in Figur 2 lediglich vier dargestellt. Die Plattensegmente PLC, PLD sind wiederum über ein Kurzschlußelement SH in Form eines n-Kanal- Transistors miteinander verbunden.

Die beiden Bitleitungen BLi jedes Plattensegments sind mit den Eingängen eines Leseverstärkers SA verbunden. Die Leseverstärker SA werden über eine erste Potentialleitung L1 mit dem niedrigen Versorgungspotential GND und über eine zweite Potentialleitung L2 mit einem hohen Versorgungspotential VDD versorgt. Jede Bitleitung BLi ist über je ein Kurzschlußelement SE in Form eines n-Kanal-Transistors mit der ersten Potentialleitung L1 verbunden. Die Gates der Kurzschlußelememte SE sind mit einem Signal S verbunden.

Die Funktionsweise der in Figur 2 gezeigten Schaltung ist folgende: In der Normalbetriebart wird lediglich eine der Wortleitungen WLi aktiviert. Außerdem wird anschließend nur das Potential eines der Plattensegmente PLC, PLD gepulst, während das Potential des anderen Plattensegments konstant bleibt. Somit erfolgt ein Zugriff auf genau eine der Speicherzellen MC. Bei einem Lesezugriff wird das sich dabei einstellende Potential auf der jeweiligen Bitleitung BLi durch den Leseverstärker SA verstärkt.

In der Testbetriebsart werden mehrere der Wortleitungen WLi gleichzeitig aktiviert, so das eine große Anzahl von Speicherzellen MC leitend mit den Bitleitungen BLi verbunden wird. Anschließend werden gleichzeitig beide Plattensegmente PLC, PLD mit entgegengesetzten Pegeln gepulst. Der Verlauf der Plattenpotentiale V_{PC}, V_{PD} sowie das Steuersignal EQ des Kurzschlußelements SH ist identisch mit demjenigen beim Ausführungsbeispiel gemäß Figur 1 und daher auch der Figur 3 zu entnehmen.

Die Kurzschlußelemente SE sind in der Normalbetriebsart grundsätzlich nicht leitend. Gleichzeitig zum Pulsen der Plattenpotentiale V_{PC}, V_{PD} werden die Kurzschlußelemente SE in der Testbetriebsart über das Signal S leitend geschaltet, so daß alle Bitleitungen BLi mit der ersten Potentialleitung L1 verbunden sind. Während das Potential eines der Plattensegmente PLC, PLD eine positive Flanke aufweist und somit positive Ladungen von den mit diesem Plattensegment verbundenen Speicherzellen MC auf die zugehörigen Bitleitungen fließen, weist das Potential des jeweils anderen Plattensegments eine negative Flanke auf, so daß negative Ladungen aus den mit diesem Plattensegment verbunden Speicherzellen MC auf die zugehörigen Bitleitungen fließen. Über die Kurzschlußelemente SE fließen sowohl die positiven Ladungen von der dem einen Plattensegment zugeordneten Bitleitung als auch die negativen Ladungen von der dem anderen Plattensegment zugeordneten Bitleitung zur ersten Potentialleitung L1. Auf diese Weise erfolgt mittels der ersten Potentialleitung L1 eine Kompensation der mit unterschiedlichen Vorzeichen versehenen Ladungsströme. Es wird also, ähnlich wie beim Ausführungsbeispiel gemäß Figur 1, ein Abbau der durch das Pulsen der Plattenpotentiale erzeugten Ladungen erreicht.

Obwohl beim Ausführungsbeispiel gemäß Figur 2 jedem Plattensegment PLC, PLD lediglich zwei der Bitleitungen BLi zugeordnet sind, ist es möglich, daß bei anderen Ausführungsbeispielen eine größere Anzahl von Bitleitungen pro Plattensegment vorhanden ist, die über jeweils ein Kurzschlußelement SE mit der ersten Potentialleitung L1 verbunden sind.

Auch beim Ausführungsbeispiel gemäß Figur 2 kann eine Abwandlung dahingehend erfolgen, daß in der Testbetriebsart nur eine der Wortleitungen WLi oder alle Wortleitungen WLi gleichzeitig aktiviert werden.

Es ist zu beachten, daß bei den in den Figuren 1 und 2 dargestellten Ausführungsbeispielen in Wirklichkeit eine große Anzahl von Plattensegmenten PLA, PLB; PLC, PLD vorhanden sind, wobei in der Testbetriebsart jeweils zwei benachbarte Segmente gleichzeitig gepulst werden.

Bei anderen Ausführungsbeispielen der Erfindung können auch mehr als zwei Plattensegmente gleichzeitig in der Testbetriebsart gepulst werden. Hierdurch kann die Anzahl der gleichzeitig angesprochenen Speicherzellen MC weiter erhöht werden. Es können dann weitere Kurzschlußelemente vorgesehen werden, die alle gleichzeitig in der Testbetriebsart zu pulsenden Plattensegmente miteinander verbinden und deren Steueranschlüße mit dem Steuersignal EQ verbunden sind.

Durch die beschriebene Ladungskompensation während des Pulsens der Plattensegmente in der Testbetriebsart können die Ströme auf den Bitleitungen reduziert bzw. die Ladungen auf den Bitleitungen kompensiert werden. Außerdem kann ein große Anzahl von Speicherzellen gleichzeitig einem künstlichen Alterungsprozeß unterworfen werden. Durch die Kurzschlußelemente SH wird die Leistungsaufnahme während des Testbetriebs reduziert.

Obwohl die Erfindung hier anhand von intergrierten Speichern in Form von FRAMs erläutert wurde, ist sie auf alle Speicher anwendbar, bei denen Zugriffe auf die Speicherzellen mittels gepulster Plattenpotentiale erfolgt.

Nach dem Pulsen der Plattensegmente in der Testbetriebsart, das der künstlichen Alterung der Speicherzellen dient, kann ein Zugriff auf jede einzelne Speicherzelle erfolgen, um ihre Funktionsfähigkeit zu überprüfen. Dies geschieht - gegebenenfalls nach einem vorhergehenden Schreibzugriff - durch einen Lesezugriff, der genau wie in der Normalbetriebsart durchgeführt wird.

## Patentansprüche

1. Integrierter Speicher
- mit Speicherzellen (MC), die innerhalb eines Zellenfeldes entlang von Bitleitungen (BLi), Wortleitungen (WLi) und wenigstens zwei Plattensegmenten (PLA, PLB; PLC, PLD) angeordnet sind und jeweils einen Auswahltransistor (T) und einen Speicherkondensator (C) aufweisen,
- bei dem eine Elektrode jedes Speicherkondensators (C) über den zugehörigen Auswahltransistor (T) mit einer der Bitleitungen (BLi) und eine andere Elektrode mit einem der Plattensegmente (PLA, PLB; PLC, PLD) verbunden ist,
- bei dem ein Steueranschluß jedes Auswahltransistors (T) mit einer der Wortleitungen (WLi) verbunden ist,
- mit einer Normalbetriebsart, in der bei Zugriffen auf die Speicherzellen (MC) das Potential jeweils nur eines der Plattensegmente (PLA, PLB; PLC, PLD) gepulst wird, **gekennzeichnet durch** eine Testbetriebsart, in der gleichzeitig die Potentiale beider Plattensegmente (PLA, PLB; PLC, PLD) gepulst werden.

2. Integrierter Speicher nach Anspruch 1,
bei dem die Potentiale der beiden Plattensegmente (PLA, PLB; PLC, PLD) in der Testbetriebsart gleichzeitig in jeweils entgegengesetzter Richtung gepulst werden.

3. Integrierter Speicher nach Anspruch 2,
- bei dem die Potentiale beider Plattensegmente in der Testbetriebsart jeweils durch zwei aufeinanderfolgende Pulse mit jeweils entgegengesetzten Pegeln gepulst werden
- und der ein Kurzschlußelement (SH) aufweist, das die beiden Plattensegmente (PLA, PLB; PLC, PLD) miteinander verbindet und das vor dem zweiten Pulsen der Plattenpotentiale vorübergehend leitend geschaltet ist.

4. Integrierter Speicher nach Anspruch 2 oder 3,
- bei dem die Plattensegmente (PLA, PLB) parallel zu den Wortleitungen (WLi) verlaufen
- und bei dem in der Testbetriebsart pro Plattensegment (PLA, PLB) wenigstens eine der zugehörigen Wortleitungen (WLi) während des Pulsens der Plattenpotentiale aktiviert ist.

5. Integrierter Speicher nach Anspruch 2 oder 3,
- dessen Plattensegmente (PLC, PLD) parallel zu den Bitleitungen (BLi) verlaufen,
- bei dem in der Testbetriebsart pro Plattensegment (PLA, PLB) wenigstens eine der zugehörigen Wortleitungen (WLi) während des Pulsens der Plattenpotentiale aktiviert ist,
- mit einer Potentialleitung (L1) für ein festes Potential (GND),
- und mit wenigstens zwei Kurzschlußelementen (SE), über die jeweils eine der jedem Plattensegment zugeordneten Bitleitungen (BLi) mit der Potentialleitung (L1) verbunden ist und die in der Testbetriebsart während des Pulsens der Plattenpotentiale beide leitend sind.

6. Integrierte Speicher nach Anspruch 4 oder 5,
bei dem in der Testbetriebsart pro Plattensegment (PLA, PLB; PLC, PLD) mehr als eine Wortleitung (WLi) gleichzeitig aktiviert ist.

7. Integrierter Speicher nach einem der vorstehenden Ansprüche,
bei dem die beiden Plattensegmente (PLA, PLB; PLC, PLD) benachbart zueinander angeordnet sind.

## Claims

1. Integrated memory
- having memory cells (MC), which are arranged within a cell array along bit lines (BLi), word lines (WLi) and at least two plate segments (PLA, PLB; PLC, PLD) and each have a selection transistor (T) and a storage capacitor (C),
- in which one electrode of each storage capacitor (C) is connected via the associated selection transistor (T) to one of the bit lines (BLi) and another electrode is connected to one of the plate segments (PLA, PLB; PLC, PLD),
- in which a control terminal of each selection transistor (T) is connected to one of the word lines (WLi),
- having a normal operating mode, in which the potential of only one of the plate segments (PLA, PLB; PLC, PLD) in each case is pulsed in the event of accesses to the memory cells (MC), **characterized by** a test operating mode, in which the potentials of both plate segments (PLA, PLB; PLC, PLD) are pulsed simultaneously.

2. Integrated memory according to Claim 1,
in which the potentials of the two plate segments (PLA, PLB; PLC, PLD) are pulsed simultaneously in each case in the opposite direction in the test operating mode.

3. Integrated memory according to Claim 2,
- in which the potentials of both plate segments are pulsed, in the test operating mode, in each case by two successive pulses with opposite levels in each case,
- and which has a short-circuiting element (SH), which connects the two plate segments (PLA, PLB; PLC, PLD) to one another and is temporarily switched on prior to the second pulsing of the plate potentials.

4. Integrated memory according to Claim 2 or 3,
- in which the plate segments (PLA, PLB) run parallel to the word lines (WLi),
- and in which, in the test operating mode, for each plate segment (PLA, PLB), at least one of the associated word lines (WLi) is activated during the pulsing of the plate potentials.

5. Integrated memory according to Claim 2 or 3,
- whose plate segments (PLC, PLD) run parallel to the bit lines (BLi),
- in which, in the test operating mode, for each plate segment (PLA, PLB), at least one of the associated word lines (WLi) is activated during the pulsing of the plate potentials,
- having a potential line (L1) for a fixed potential (GND),
- and having at least two short-circuiting elements (SE), via which one of the bit lines (BLi) assigned to each plate segment is respectively connected to the potential line (L1) and which are both in the on state in the test operating mode during the pulsing of the plate potentials.

6. Integrated memory according to Claim 4 or 5,
in which more than one word line (WLi) is activated simultaneously for each plate segment (PLA, PLB; PLC, PLD) in the test operating mode.

7. Integrated memory according to one of the preceding claims,
in which the two plate segments (PLA, PLB; PLC, PLD) are arranged adjacent to one another.

## Revendications

1. Mémoire intégrée
- comprenant des cellules (MC) de mémoire qui sont disposées dans un champ de cellules, le long de lignes (BLi) de bit, de lignes (WLi) de mot et d'au moins deux segments (PLA, PLB; PLC; PLD) de plaque, et qui ont respectivement un transistor (T) de sélection et un condensateur (C) d'accumulation,
- dans laquelle une électrode de chaque condensateur (C) d'accumulation est reliée par le transistor (T) de sélection associé à l'une des lignes (BLi) de bit et une autre électrode à l'un des segments (PLA, PLB ; PLC, PLD) de plaque,
- dans laquelle une borne de commande de chaque transistor (T) de sélection est reliée à l'une des lignes (WLi) de mot ,
- ayant un type de fonctionnement normal, dans lequel, en cas d'accès aux cellules (MC) de mémoire, le potentiel de respectivement seulement l'un des segments (PLA, PLB ; PLC, PLD) de plaque est pulsé, **caractérisée par** un type de fonctionnement de test, dans lequel les potentiels des deux segments (PLA, PLB ; PLC, PLD) de plaque sont pulsés simultanément.

2. Mémoire intégrée suivant la revendication 1,
dans laquelle les potentiels des deux segments (PLA, PLB; PLC, PLD) de plaque sont, dans le mode de fonctionnement de test, pulsés simultanément en sens opposé.

3. Mémoire intégrée suivant la revendication 2,
- dans laquelle les potentiels des deux segments de plaque sont, dans le type de fonctionnement de test, pulsés en ayant des niveaux opposés par respectivement deux impulsions successives,
- et qui a un élément (SH) de court-circuit, qui relie entre eux les deux segments (PLA, PLB; PLC, PLD) de plaque et qui est conducteur transitoirement avant la deuxième impulsion des potentiels de plaque.

4. Mémoire intégrée suivant la revendication 2 ou 3,
- dans laquelle les segments (PLA, PLB) de plaque s'étendent parallèlement aux lignes (WLi) de mot,
- et dans laquelle, dans le type de fonctionnement de test, au moins l'une des lignes (WLi) de mot associée est, par segment (PLA, PLB) de plaque, activée pendant l'impulsion des potentiels de plaque.

5. Mémoire intégrée suivant la revendication 2 ou 3,
- dont les segments (PLC; PLD) de plaque s'étendent parallèlement aux lignes (BLi) de bit,
- dans lequel, dans le type de fonctionnement de test, au moins l'une des lignes (WLi) de mot associée est, par segment (PLA, PLB) de plaque, activée pendant l'impulsion des potentiels de plaque,
- comprenant une ligne (L1) de potentiel pour un potentiel (GND) fixe,
- comprenant au moins deux éléments (SE) de court-circuit par lesquels respectivement l'une des lignes (BLi) de bit associée à chaque segment de plaque est reliée à la ligne (L1) de potentiel et qui sont tous deux conducteurs, dans le type de fonctionnement de test, pendant l'impulsion des potentiels de plaque.

6. Mémoire intégrée suivant la revendication 4 ou 5,
dans laquelle, dans le type de fonctionnement de test, plus d'une ligne (WLi) de mot est par segment (PLA, PLB; PLC, PLD) de plaque, activée simultanément.

7. Mémoire intégrée suivant l'une des revendications précédentes, dans laquelle les deux segments (PLA, PLB; PLC, PLD) de plaque sont disposés en étant voisins l'un de l'autre.
